# EUROPEAN PATENT SPECIFICATION

(11) **EP 1 788 676 B1**
(45) Date of publication and mention of the grant of the patent: **04.03.2009**
(21) Application number: 06023378.0
(22) Date of filing: 09.11.2006
(51) Int. Cl.: H01S 5/40, H01S 5/024, H01S 5/022

(54) **Modular assembly utilizing laser diode subassemblies with winged mounting blocks**
Modulare Anordnung verwendend Laserdiodenbaugruppen mit Montageblöcken mit Flügeln
Ensemble modulaire utilisant des sous-ensembles de diodes laser avec blocs de montage à ailes

(30) Priority: 22.11.2005 US 739185 P; 20.12.2005 US 313068; 17.03.2006 US 378570; 17.03.2006 US 378667; 17.03.2006 US 378696; 17.03.2006 US 378697; 27.09.2006 US 527964
(43) Date of publication of application: 23.05.2007
(73) Proprietor: nLight Photonics Corporation, Vancouver WA 98665 (US)
(72) Inventor: Schulte, Derek E., Portland OR 97210 (US); Yan, Yu, Vancouver WA 98683 (US); Martinsen, Robert J., West Linn OR 97068 (US); Hodges, Aaron L., Hillsboro OR 97123 (US); Karlsen, Scott R., Battle Ground WA 98604 (US)
(74) Representative: Eisenführ, Speiser & Partner

(56) References cited:
- WO-A-20/05039001
- JP-A- 4 264 789
- US-A- 3 622 906
- US-A- 5 105 430
- US-A- 5 909 458
- US-A- 5 987 043
- US-A1- 2004 264 862
- US-A1- 2005 254 539

## Description

### FIELD OF THE INVENTION

The present invention relates generally to semiconductor lasers and, more particularly, to a laser assembly that permits the output from multiple laser diodes to be effectively and efficiently combined.

### BACKGROUND OF THE INVENTION

High power laser diodes have been widely used in industrial, graphics, medical and defense applications. The beam divergence and the relatively low output power of such lasers have, however, limited their usefulness.

The output beam of a laser diode is asymmetric due to the beam having a higher angular divergence in the direction perpendicular to the diode junction of the emitter (i.e., the fast axis of the emitter) than in the direction parallel to the diode junction (i.e., the slow axis of the emitter). As a result of the differences in beam divergence, the cross section of the output beam of a laser diode has an elliptical shape, typically requiring the use of a cylindrical lens or other optics to alter the divergence characteristics and shape the output beam for its intended use. Although beam optics can be used to reformat the output of individual laser diodes, in the past the use of such optics has made it difficult to combine multiple laser diode beams into a single beam of sufficient output power to suit many applications.

One method of combining the output beams from multiple lasers is disclosed in U.S. Patent No. 4,828,357. As shown, the output from each laser is directed using multiple mirrors in order to form a bundle of parallel beams or to cause the beams to converge into a relatively narrow region. The patent discloses that if greater power is required than can be generated by a single beam bundle, multiple bundles of parallel beams can be combined to form a beam bundle of even greater power. The patent does not specifically disclose the use of laser diodes nor does the patent disclose altering the beam shape of the individual laser beams prior to directing the beams into the beam bundle.

U.S. Patent No. 6,075,912 discloses an alternate technique for combining the output beams from multiple lasers into a single beam. In the disclosed system the output beam of each laser impinges on a discrete facet of a multi-faceted beam deflector. By properly positioning each laser relative to the facets of the beam deflector, all of the output beams are deflected into an optical fiber. The patent discloses interposing an optical system between each laser source and the corresponding beam deflector facet in order to properly image the output beam onto the deflector facet. The patent also discloses interposing an output optical system between the beam deflector and the optical fiber, the output optical system imaging the deflected output beams as a focused group of beam images into the core of the input face of the optical fiber.

U.S. Patent No. 4,716,568 discloses a laser array assembly formed from a plurality of linear laser diode array subassemblies stacked one above the other, each of the subassemblies electrically connected to the adjacent subassembly. Each linear laser diode array subassembly is made up of a plurality of individual laser emitters mounted in thermal communication with a conductive plate. Although the patent discloses several ways of stacking the subassemblies in order to form the desired 2-D laser array, the patent does not disclose any optical systems for use in combining the output beams of the individual emitters and/or subassemblies.

U.S. Patent No. 5,887,096 discloses an optical system that is used to guide the output beams from a rectilinear laser diode array to form a substantially uniform radiation field or pattern. In one disclosed embodiment, the optical system utilizes a plurality of reflectors where each reflector corresponds to an individual laser diode. In a preferred embodiment, the centers of the irradiated surface areas of the individual reflectors are situated in a straight line with the distance between a reflector and the corresponding laser diode exit facet being the same for each laser diode/reflector pair.

U.S. Patent No. 6,240,116 discloses a laser diode array designed to achieve high beam quality and brightness. In one embodiment, the array includes a pair of diode arrays in which the emitting surface planes of the two arrays are displaced from one another in a direction parallel to the one of the optical axes defined by the arrays. The optical axes of the two arrays are offset from each other in a direction perpendicular to one of the optical axes. Lenses are used to reduce the divergence of the output beams. In at least one embodiment, reflectors are used to reduce or eliminate the dead spaces between adjacent collimated beams.

Although a variety of laser diode arrays and beam combining systems have been designed, what is needed in the art is a versatile laser diode assembly which can be easily tailored to specific application needs. The present invention provides such a laser diode assembly.

### SUMMARY OF THE INVENTION

The present invention as defined in claim 1 provides a laser diode assembly comprised of a plurality of laser diode subassemblies mounted to a stepped cooling block. Each laser diode subassembly of the laser diode assembly includes a mounting block which, during laser diode subassembly mounting, is coupled to the corresponding mounting surface of the stepped cooling block. Although the laser diode subassemblies are coupled to the cooling block, liquid coolant does not flow through the subassembly mounting blocks, rather the mounting blocks are merely in thermal contact with the cooling block.

Mounted to a surface of each subassembly mounting block is a laser diode submount. The laser diode submount can be fabricated from either an electrically insulating material or an electrically conductive material. Mounted to a surface of the laser diode submount is the laser diode. The laser diode can be either a single emitter laser diode or a multi-emitter laser diode. In at least one embodiment the laser diode submount includes a pair of contact pads that are electrically coupled to the laser diode, thus providing a means of supplying power to the individual lasers.

Each subassembly mounting block includes at least one, and preferably two, extensions, also referred to as mounting block wing portions, which are used in combination with clamping members to hold the mounting blocks against the cooling block. Preferably the bottom surface of each of the mounting blocks is shaped, thus providing a means of registering the mounting block subassemblies to the cooling block. Preferably tensioned electrical interconnects are used to contact the electrical contact pads located on the laser diode submounts, thus providing a means of contacting the laser diodes without putting undue stress on the laser diode submounts. In an alternate embodiment of the invention, at least one threaded means (e.g., bolt, all-thread and nut assembly, etc.) attaches each laser diode subassembly to the corresponding cooling block mounting surface. In yet another alternate embodiment of the invention, solder or other bonding material attaches each laser diode subassembly to the corresponding cooling block mounting surface.

In at least one preferred embodiment of the invention, a beam conditioning lens is attached, for example by bonding, to each laser diode subassembly mounting block such that the output beam(s) of the laser diode passes through the lens. In one embodiment the beam conditioning lens is a cylindrical lens. Preferably a second beam conditioning lens is also attached, for example by bonding, to each laser diode subassembly mounting block such that the output beam(s) of the laser diode from a different laser diode subassembly passes through the lens. The different laser diode subassembly can be an adjacent subassembly. Alternately one or more laser diode subassemblies can be located between the second beam conditioning lens and the subassembly containing the laser diode that produces the output beam that passes through the second beam conditioning lens.

In at least one embodiment of the invention, a cooling source is coupled to the cooling block. The cooling source can be coupled to the cooling block or integrated within the cooling block, for example using cooling liquid channels. The cooling block can have a flat bottom surface, thus creating different separation distances between each mounting surface of the stepped cooling block and the cooling block bottom surface. Alternately the cooling block can have an inclined bottom surface, thus causing the separation distances between each mounting surface of the stepped cooling block and the cooling block bottom surface to be the same.

A further understanding of the nature and advantages of the present invention may be realized by reference to the remaining portions of the specification and the drawings.

### BRIEF DESCRIPTION OF THE DRAWINGS

Fig. 1 is a perspective view of the primary components of a laser diode subassembly in accordance with the invention;
Fig. 2 is a perspective view of the assembled laser diode subassembly of Fig. 1, minus the second conditioning lens;
Fig. 3 is a perspective view of the assembled laser diode subassembly of Fig. 1, including the second conditioning lens associated with another (not shown) laser diode subassembly;
Fig. 4 illustrates the relationship between the second conditioning lens and a specific laser diode subassembly;
Fig. 5 illustrates the relationship between the second conditioning lens and a specific laser diode subassembly different from that shown in Fig. 4;
Fig. 6 is a perspective view of the bottom surface of the subassembly mounting block shown in Fig. 1;
Fig. 7 is a perspective view of an alternate bottom surface shape;
Fig. 8 is an illustration of a cooling block for use with a laser diode subassembly such as those shown in Figs. 1-3 and 6;
Fig. 9 is an illustration of the cooling block of Fig. 8 populated with two rows of laser diode subassemblies;
Fig. 10 is an illustration of the assembly of Fig. 9 with clamping members to hold the laser diode subassemblies in place;
Fig. 11 is an illustration of the assembly of Fig. 10 with interconnects in place;
Fig. 12 is a cross-sectional view of an uncompressed interconnect;
Fig. 13 is a cross-sectional view of the interconnect assembly shown in Fig. 12 making contact with a laser diode contact pad;
Fig. 14 is an illustration of an alternate means of mounting the subassemblies to the cooling block;
Fig. 15 is an illustration of a cooling block similar to that shown in Fig. 8, except for the use of an inclined cooling plane; and
Fig. 16 is an illustration of an assembly similar to that shown in Fig. 11, except that the assembly includes only a single row of laser diode subassemblies.

### DESCRIPTION OF THE SPECIFIC EMBODIMENTS

The present invention provides the system designer with the means to tailor a laser diode assembly to the specific needs of a particular application. In order to provide this versatility, the system utilizes a laser diode subassembly that can be mounted in a variety of configurations.

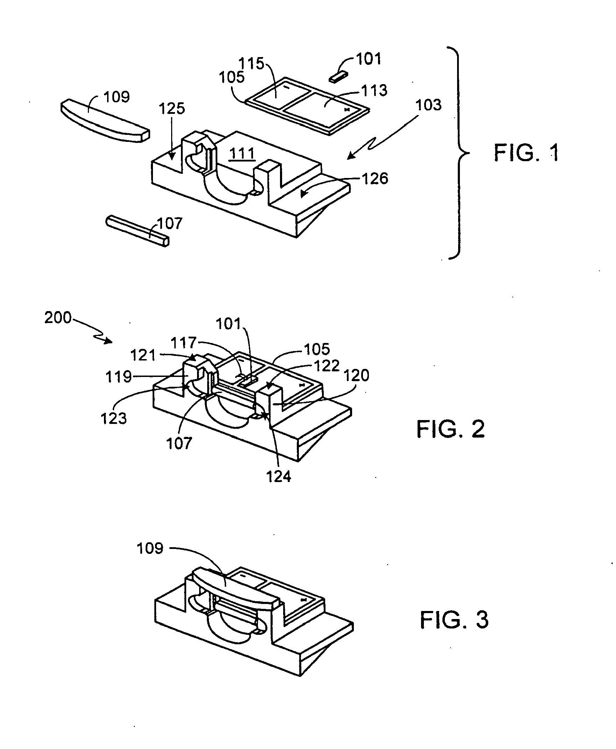

Figs. 1-3 illustrate a laser diode subassembly utilizing a single emitter laser diode 101. In addition to the laser diode 101, the primary components associated with the laser diode subassembly are the subassembly mounting block 103, submount 105, first conditioning lens 107 and second conditioning lens 109. As described in detail below, although second conditioning lens 109 is mounted to subassembly mounting block 103, it is used with the output beam of a laser diode mounted to another laser diode subassembly that is not shown in Figs. 1-3.

Subassembly mounting block 103 provides a convenient means for registering the various components of the laser diode subassembly as well as a means of registering the individual laser diode subassemblies within the cooling block as described further below. Additionally, mounting block 103 provides sufficient heat dissipation to allow individual laser diode subassemblies to be tested in either pulsed or CW mode prior to mounting the subassemblies within the cooling block. With respect to the laser diode subassembly, in the preferred embodiment laser diode 101 is not attached directly to subassembly mounting block 103, rather it is mounted to submount 105 which, in turn, is mounted to surface 111 of mounting block 103. Preferably submount 105 as well as the means used to attach submount 105 to mounting block 103 are both materials with a high coefficient of thermal conductivity, thus insuring that the heat produced by laser diode 101 is efficiently coupled to mounting block 103. Additionally the coefficient of thermal expansion for the material selected for submount 105 is matched, to the degree possible, to laser diode 101 in order to prevent debonding or damage to the laser diode during operation. In at least one embodiment of the invention, submount 105 is soldered to mounting block 103 using indium solder.

Submount 105 can be fabricated from either an electrically conductive (e.g., copper, copper tungsten, etc.) or an electrically insulative (e.g., aluminum nitride, beryllium oxide, CVD diamond, silicon carbide, etc.) material. In the embodiment illustrated in Figs. 1 and 2, submount 105 is fabricated from an electrically insulating ceramic. The material used to bond laser diode 101 to submount 105 is selected, at least in part, on the composition of submount 105 and/or the composition of any layers (e.g., contact pads) interposed between submount 105 and laser diode 101. In the illustrated embodiment, electrically conductive contact pads 113/115 are deposited or otherwise formed on the top surface of submount 105. Contact pads 113/115 can be formed, for example, of gold over nickel plating while a gold-tin bonding material can be used to bond laser diode 101 to contact pad 113. It will be appreciated that there are a variety of materials well known in the industry that are suitable for use as contact pads as well as laser diode bonding material.

In a preferred embodiment of the invention, one contact (e.g., anode) of laser diode 101 is on its bottom surface, thus allowing one diode contact to be made by bonding the laser diode to one of the contact pads (e.g., pad 113) using an electrically conductive material. A wire or ribbon bond 117, or alternately another type of contacting member (not shown), is then used to electrically couple the second contact (e.g., cathode) of each laser diode to the second contact pad 115. It will be appreciated that the invention is not limited to this contact arrangement. For example, both the anode and the cathode can be coupled to a pair of contact pads using multiple wire/ribbon bonds.

First conditioning lens 107, which in at least one embodiment is a cylindrical lens, is preferably located between extended arm portions 119/120 of mounting block 103, respectively. Typically lens 107 is located immediately adjacent to the exit facet of laser diode 101. Once lens 107 is properly positioned, it is bonded into place. The purpose of conditioning lens 107 is to reduce the divergence of laser diode 101 in the fast axis, preferably to a value that is the same as or less than the divergence in the slow axis.

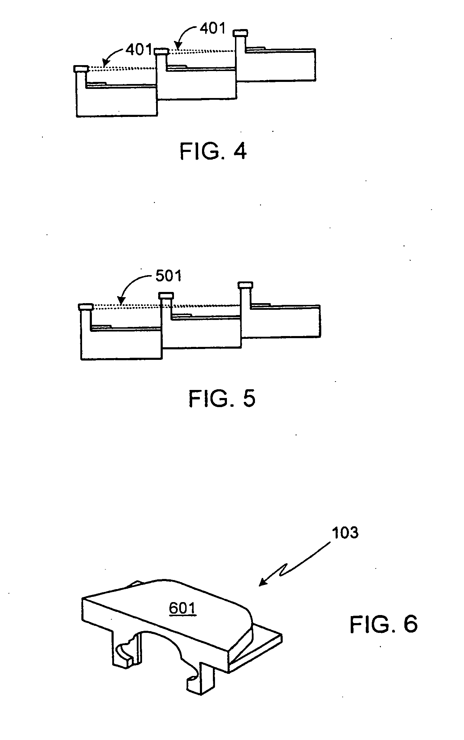

In order to properly condition the output beam of laser diode 101, preferably a second conditioning lens 109 is used. It should be understood that the specific second conditioning lens 109 shown in Figs. 1-3, although mounted to the top surfaces 121 and 122 of respective arm portions 119 and 120, is not used to condition the beam from the illustrated laser diode 101. Rather the illustrated conditioning lens 109 is used to condition the output beam from an adjacent laser diode subassembly (e.g., beam 401 in Fig. 4), or the output beam from a laser diode subassembly that is more than one subassembly removed from the subassembly (e.g., beam 501 in Fig. 5). It will be appreciated that the focal length of second conditioning lens 109 as well as the height of arm portions 119 and 120 is dependent on which laser diode output beam is intended to pass through which second conditioning lens (i.e., the number of laser diode subassemblies separating the second conditioning lens from the laser diode source).

In the preferred embodiment of the invention, registration regions 123 and 124 are machined, or otherwise formed, within extended arm portions 119 and 120, respectively. A third lens, for example a volume Bragg grating, can be mounted within registration regions 123 and 124.

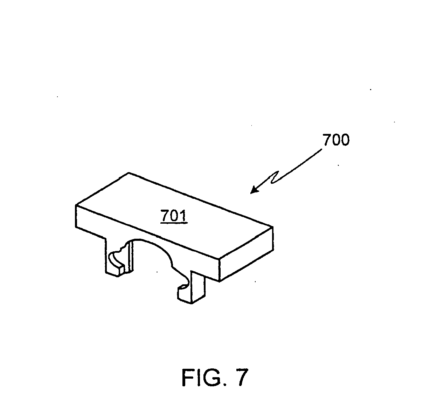

As previously noted, in addition to provide a means of registering the individual subassembly components, preferably mounting block 103 is also used to register the individual subassemblies within the cooling block. In order to better perform this function, in at least one preferred embodiment of the invention the bottom surface of mounting block 103 is shaped. Fig. 6 illustrates a preferred contoured bottom surface 601. It will be appreciated that the invention is not limited to this specific shape. For example, Fig. 7 illustrates a bottom surface 701 of an alternate mounting block 700. In this embodiment the bottom surface of the mounting block retains the same perimeter shape as the upper surface (as illustrated in Fig. 1).

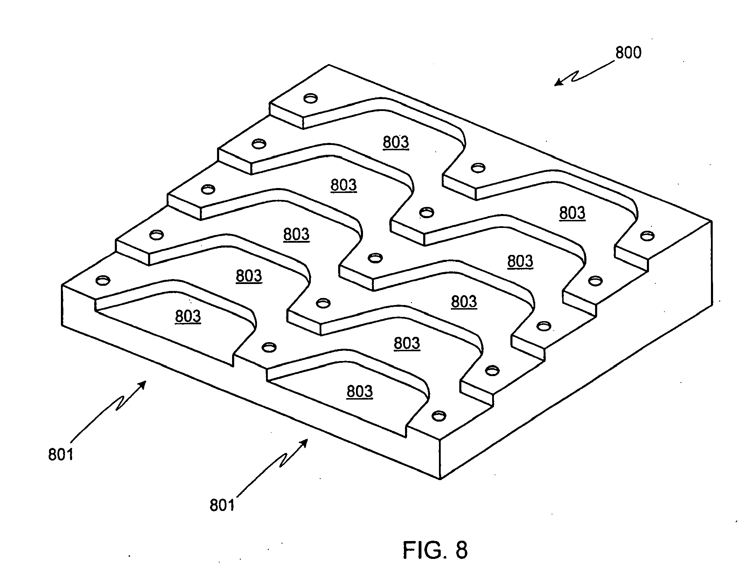

Fig. 8 is a perspective view of a preferred cooling block 800 for use with the laser diode subassemblies shown in Figs. 1-3 and 6. As shown, cooling block 800 includes two rows 801 of stepped mounting surfaces 803. By stepping the mounting surfaces the output beams from the attached laser diode subassemblies (not shown in this figure) are allowed to exit the assembly unimpeded. Each mounting surface 803 is configured to accept a laser diode assembly. More specifically, the shape of each mounting surface 803 corresponds to that of bottom surface 601 of mounting block 103, thus providing a simple means of registering the subassemblies within the cooling block. It will be appreciated that if the bottom surface of the mounting block is differently shaped, for example as described relative to Fig. 7, the stepped mounting surfaces are correspondingly shaped. Preferably the mounting blocks, described in detail above, are fabricated from a material with a high coefficient of thermal conductivity (e.g., copper), thus providing an efficient thermal path between laser diode 101 and the cooling block. During use, preferably either the cooling block is thermally coupled to a cooling source (e.g., thermoelectric cooler, multi-channel cooling block), or the cooling source is integrated within the cooling block (e.g., integral liquid coolant conduits within the cooling block that are coupled to a suitable coolant pump).

The cooling block shown in Fig. 8 is configured to accept two rows of laser diode subassemblies, each row containing five subassemblies. The output beams from the two rows of subassemblies can either be combined into a single beam using known optical techniques, or the assembly can be used to produce two separate output beams. It should be appreciated that the present invention is not limited to this particular configuration. For example, a device in accordance with the invention can include more or less rows of subassemblies. Similarly, each row can be configured to include more or less subassemblies than the five that cooling block 800 is configured to accept.

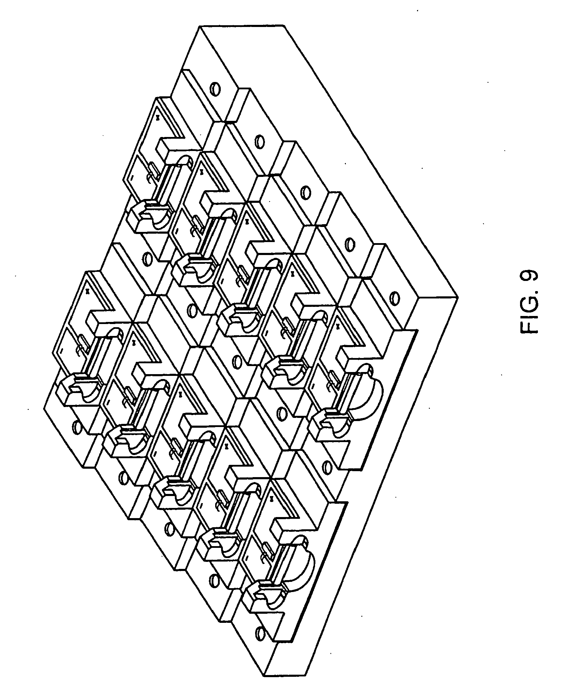

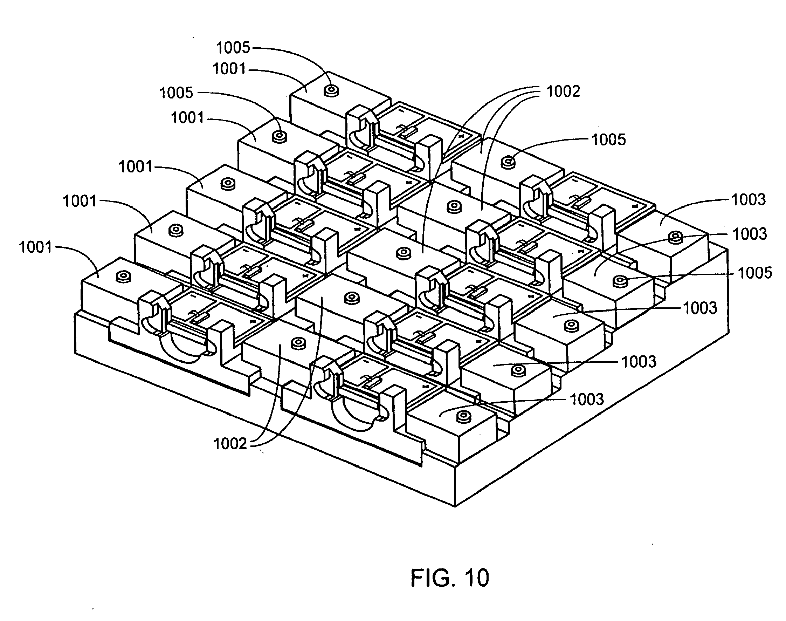

It will be appreciated that there are numerous techniques that can be used to mount the laser diode subassemblies to the cooling block, these techniques using various arrangements of clamping members, bolts and/or bonding materials (e.g., solder, adhesive). Figs. 9 and 10 illustrate a preferred mounting technique in which mounting block wing portions 125/126, which extend beyond submount mounting surface 111 of each mounting block 103, are used to hold the mounting blocks in place within the cooling block. There are several benefits associated with the use of wing portions 125/126 to clamp each subassembly within the cooling block. First, wing portions 125/126 provide a means of insuring that the subassemblies are held tightly in place, thus improving the transfer of heat from the laser diodes, through the mounting blocks, and into the cooling block. Second, by clamping mounting block surfaces that are removed from surface 111, the risk of damaging submount 105 during assembly is significantly diminished.

Fig. 9 shows ten laser diode subassemblies 200 positioned within mounting block 800. Note that for the sake of clarity, second conditioning lens 109 is not shown in Figs. 9-11. It will be understood, however, that in normal use there is a second conditioning lens, e.g., lens 109, associated with each laser diode subassembly. The second conditioning lens for the lowermost laser diode subassembly or subassemblies are mounted to a stand-alone lens carrier that is either integral to, or independent of, the cooling block.

In the preferred embodiment, and as illustrated in Fig. 10, each laser diode subassembly 200 is held in place with a pair of clamping members (e.g., members 1001, 1002, 1003). In the illustrated embodiment, due to the use of multiple rows of laser diode subassemblies, preferably between rows a single clamping member 1002 is used to clamp two different subassemblies. It should be understood, however, that even with multiple rows of subassemblies, each subassembly can utilize two independent clamping members, i.e., one on either wing portion. Other clamping variations are clearly envisioned by the inventors, for example using stepped clamping members that can be used to hold more than one subassembly in place (for example, combining several members 1003 into a single member). It will also be appreciated that other variations are possible depending upon the heights of the wing portions relative to the cooling block. In the preferred embodiment, bolts 1005 secure each clamping member to the cooling. Alternately, all-thread/nut assemblies or other threaded means can be used to secure the clamping members, and thus the subassemblies, in place.

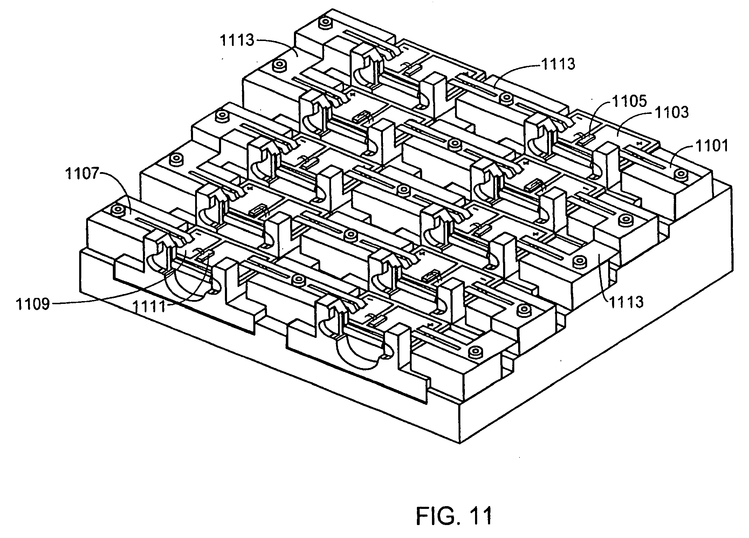

It will be appreciated that there are countless methods of contacting the individual laser diodes 101, typically using contact pads such as pads 113/115 described relative to the earlier figures. In general, the means used to contact the individual laser diodes depends upon whether the intent is to connect the laser diodes in series, or in parallel, or in groups (for example, in groups of laser diodes emitting specific wavelengths), or individually thereby providing individual laser diode addressability. Fig. 11 illustrates a preferred interconnect configuration that serially couples the laser diodes together. In the illustrated configuration, interconnect 1101 is electrically coupled to anode contact pad 1103 of laser diode 1105 while interconnect 1107 is electrically coupled to cathode contact pad 1109 of laser diode 1111. Other interconnects (e.g., interconnects 1113) are used to serially couple together the other laser diodes of the stack. Note that in the illustrated configuration, the polarity of the second and fourth rows of laser diodes is reversed relative to the polarity of the first, third and fifth rows of laser diodes. It will be appreciated that in the illustrated embodiment, if the cooling block is electrically conductive, the electrical interconnects must be electrically isolated from the cooling block (for example, using electrically insulating sleeves/washers).

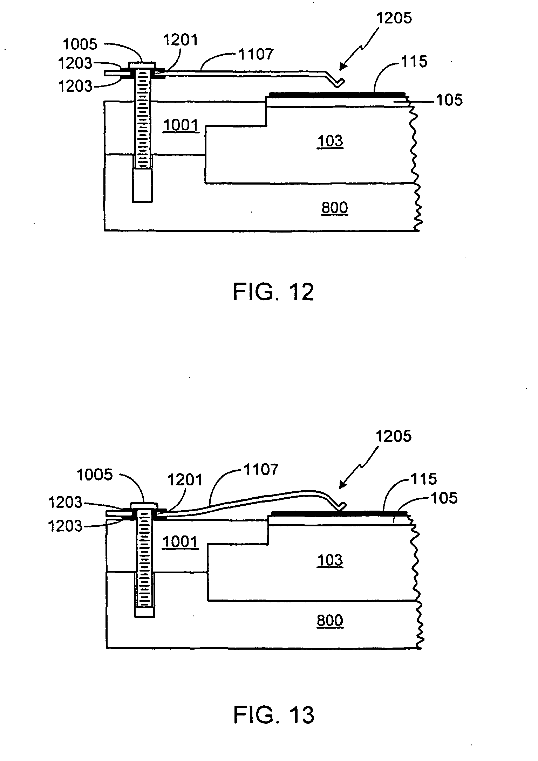

Although it will be appreciated that there are numerous methods of electrically coupling to the laser diodes, in a preferred embodiment shown in Figs. 12 and 13, the interconnects are fabricated from a relatively thin electrically conductive material, or materials, that have sufficient springiness to provide a simple means of contacting the contacting pads. Fig. 12 is a cross-sectional view of an exemplary interconnect such as interconnect 1107. In the illustrated embodiment, interconnect 1107 is prevented from shorting, via bolt 1005, using electrically insulating sleeve member 1201 and electrically insulating washers 1203. As shown in Fig. 13, when bolt 1005 holds the interconnect in place against clamping member 1001, the end portion 1205 of interconnect 1107 is held in tension against contact pad 115.

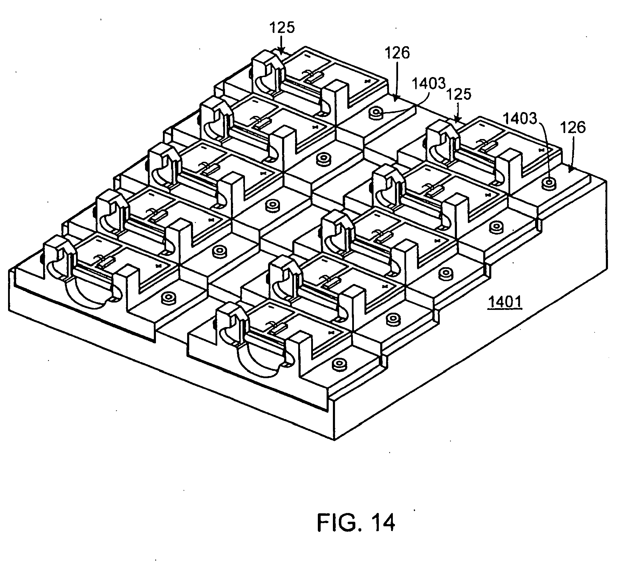

As previously noted there are countless minor variations of the invention utilizing different electrical interconnects, clamping assemblies and cooling blocks that are clearly envisioned by the inventors. For example, Fig. 14 illustrates an embodiment similar to that shown in Fig. 9 except that each mounting block wing portion 125 and 126 is directly bolted to cooling block 1401 with a bolt 1403. As with Fig. 9, for the sake of illustration clarity neither the second conditioning lens nor the electrical interconnects for each subassembly are shown.

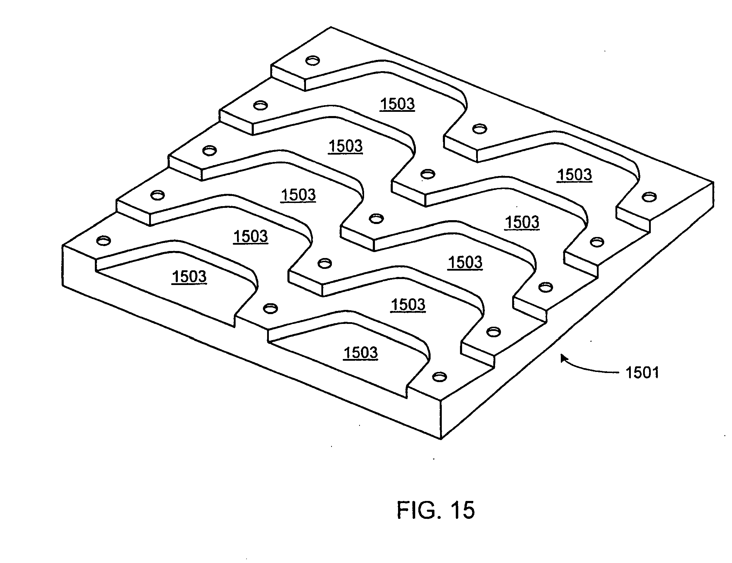

As the cooling block (e.g., cooling block 800 and 1401) is comprised of a series of steps onto which the laser diode subassemblies are mounted, the cooling rate and thus the operating temperature of the individual laser subassemblies varies depending upon the distance between the cooling source coupled to the cooling block and the individual subassemblies. Since the operating wavelength of a laser diode is temperature dependent, the inventors have found that the operating temperature variations between subassemblies that arise due to the stepped cooling block can be used to match laser diode subassembly wavelengths. Accordingly in at least one embodiment of the invention, the output wavelength of each subassembly is determined based on the subassembly's position within the cooling block. Then each subassembly is positioned within the cooling block to provide the closest possible match to the desired output wavelength of the entire assembly. In an alternate embodiment of a cooling block shown in Fig. 15, the bottom surface 1501 of the cooling block is inclined. As a result of this configuration, each mounting surface 1503 is the same distance from the bottom surface 1501, thus maintaining the same cooling rate for each mounted laser diode subassembly (not shown) even when thermally coupling the cooling source to the bottom surface (i.e., surface 1501) of the cooling block.

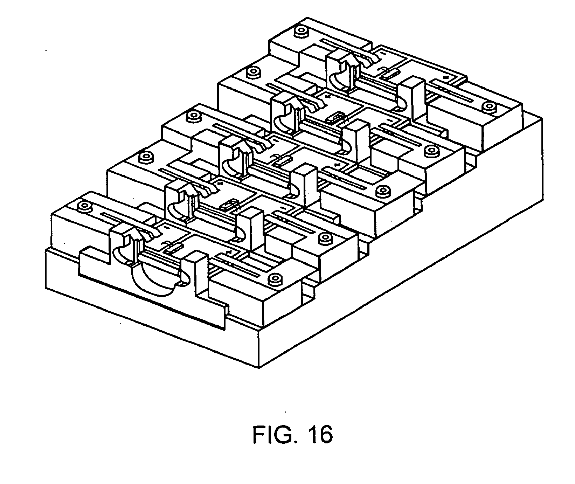

In the above figures, the illustrated exemplary configurations include two rows of subassemblies. As previously noted, however, the invention is not limited to two rows nor is the invention limited to a specific number of subassemblies per row. For example, Fig. 16 is an illustration of a laser diode assembly utilizing a single row of laser diode subassemblies.

As will be understood by those familiar with the art, the present invention may be embodied in other specific forms without departing from the spirit or essential characteristics thereof. Accordingly, the disclosures and descriptions herein are intended to be illustrative, but not limiting, of the scope of the invention which is set forth in the following claims.

## Claims

1. A laser diode assembly comprising:
a cooling block comprised of a plurality of stepped mounting surfaces;
a plurality of laser diode subassemblies, wherein each of said laser diode subassemblies is comprised of:
a mounting block, wherein said mounting block does not include integral coolant passages, and wherein said mounting block further comprises at least one wing portion;
a laser diode submount mounted to said mounting block; and
a laser diode mounted to said laser diode submount; and
means for clamping at least one of said at least one wing portions of each of said mounting blocks to said cooling block, wherein each output beam from said plurality of laser diode subassemblies is displaced relative to an adjacent output beam from an adjacent laser diode subassembly.

2. The laser diode assembly of claim 1, wherein each mounting block of said plurality of laser diode subassemblies is comprised of a pair of said wing portions.

3. The laser diode assembly of claim 1, wherein said clamping means further comprises a plurality of clamping members.

4. The laser diode assembly of claim 3, wherein said clamping means is further comprised of a plurality of threaded means threadably coupled into said cooling block.

5. The laser diode assembly of claim 4, wherein at least one of said plurality of clamping members and at least one of said plurality of threaded means secures at least one of said wing portions of each of said mounting blocks to said cooling block.

6. The laser diode assembly of claim 4, wherein at least one of said plurality of clamping members and at least one of said plurality of threaded means secures each of said wing portions of each of said mounting blocks to said cooling block.

7. The laser diode assembly of claim 4, wherein said plurality of threaded means is comprised of a plurality of bolts.

8. The laser diode assembly of claim 1, wherein each mounting block of said plurality of laser diode subassemblies is comprised of a pair of said wing portions, wherein said clamping means further comprises a plurality of clamping members, wherein said clamping means further comprises a plurality of threaded means threadably coupled into said cooling block, and wherein at least one of said plurality of clamping members and at least one of said plurality of threaded means secures each of said wing portions of said pair of wing portions of each of said mounting blocks to said cooling block.

9. The laser diode assembly of claim 1, wherein said clamping means is comprised of a plurality of threaded means threadably coupled into said cooling block, wherein at least one of said plurality of threaded means secures at least one of said wing portions of each of said mounting blocks to said cooling block.

10. The laser diode assembly of claim 9, wherein said plurality of threaded means is comprised of a plurality of bolts.

11. The laser diode assembly of claim 1, wherein each mounting block of said plurality of laser diode subassemblies further comprises a shaped bottom surface, and wherein each stepped mounting surface of said cooling block is correspondingly shaped such that each mounting block is registered to each stepped mounting surface.

12. The laser diode assembly of claim 1, wherein said plurality of stepped mounting surfaces are of an increasing height as measured relative to a plane corresponding to a lowermost portion of a cooling block bottom surface.

13. The laser diode assembly of claim 1, wherein a bottom surface of said cooling block is inclined.

14. The laser diode assembly of claim 13, wherein a separation distance corresponding to the distance between each of said plurality of stepped mounting surfaces of said cooling block and said inclined cooling block bottom surface is the same for each of said plurality of stepped mounting surfaces.

15. The laser diode assembly of claim 1, wherein each of said laser diode subassemblies further comprises a first beam conditioning lens mounted to said mounting block, wherein an output beam from said laser diode passes through said first beam conditioning lens.

16. The laser diode assembly of claim 15, wherein each of said laser diode subassemblies further comprises a second beam conditioning lens mounted to said mounting block, wherein a second output beam from a different laser diode subassembly of said plurality of laser diode subassemblies passes through said second beam conditioning lens.

17. The laser diode assembly of claim 1, further comprising a plurality of electrical interconnects, wherein said clamping means maintains each of said plurality of electrical interconnects in electrical contact with a corresponding plurality of electrical contact pads, wherein said plurality of electrical contact pads are located on said laser diode submounts of said laser diode subassemblies.

18. The laser diode assembly of claim 1, wherein said laser diode is a single emitter laser diode.

19. The laser diode assembly of claim 1, wherein said laser diode is a multi-emitter laser diode.

## Patentansprüche

1. Laserdiodenbaueinheit mit:
einem Kühlblock mit einer Vielzahl von gestuften Befestigungsflächen;
einer Vielzahl von Laserdiodenunterbaueinheiten, wobei jede der Laserdiodenunterbaueinheiten besteht aus:
einem Befestigungsblock, wobei der Befestigungsblock keine integralen Kühlmitteldurchgänge beinhaltet, und wobei der Befestigungsblock weiter zumindest einen Flügelteil aufweist;
einer Laserdiodenunterbefestigung, die auf dem Befestigungsblock befestigt ist; und
einer Laserdiode, die auf der Laserdiodenunterbefestigung befestigt ist; und
Mitteln zum Spannen mindestens eines des mindestens einen Flügelteils jedes der Befestigungsblöcke auf dem Kühlblock, wobei jeder Ausgangsstrahl der Vielzahl von Laserdiodenunterbaueinheiten relativ zu einem benachbarten Ausgangstrahl einer benachbarten Laserdiodenunterbaueinheit versetzt ist.

2. Laserdiodenbaueinheit nach Anspruch 1, wobei jeder Befestigungsblock der Vielzahl von Laserdiodenunterbaueinheiten ein Paar aus Flügelteilen aufweist.

3. Laserdiodenbaueinheit nach Anspruch 1, wobei die Spannmittel weiter eine Vielzahl von Spannelementen aufweisen.

4. Laserdiodenbaueinheit nach Anspruch 3, wobei die Spannmittel weiter eine Vielzahl von Gewindemitteln aufweisen, die durch ein Gewinde mit dem Kühlblock verbunden sind.

5. Laserdiodenbaueinheit nach Anspruch 4, wobei mindestens eine der Vielzahl von Spannelementen und mindestens eines der Vielzahl von Gewindemitteln mindestens eines der Flügelteile jedes der Befestigungsblöcke auf dem Kühlblock sichert.

6. Laserdiodenbaueinheit nach Anspruch 4, wobei mindestens eines der Vielzahl von Spannelementen und mindestens eines der Vielzahl der Gewindemittel jedes der Flügelteile jedes der Befestigungsblöcke auf dem Kühlblock sichert.

7. Laserdiodenbaueinheit nach Anspruch 4, wobei die Vielzahl von Gewindemitteln aus einer Vielzahl von Schrauben besteht.

8. Laserdiodenbaueinheit nach Anspruch 1, wobei jeder Befestigungsblock der Vielzahl von Laserdiodenunterbaueinheiten ein Paar der Flügelteile aufweist, wobei die Spannmittel weiter eine Vielzahl von Spannelementen aufweisen, wobei die Spannmittel weiter eine Vielzahl von Gewindemitteln, die durch ein Gewinde mit dem Kühlblock verbunden sind, aufweisen, und wobei mindestens eines der Vielzahl von Spannelementen und mindestens eines der Vielzahl von Gewindemitteln jedes der Flügelteile des Paars aus Flügelteilen jedes der Befestigungsblöcke auf dem Kühlblock sichert.

9. Laserdiodenbaueinheit nach Anspruch 1, wobei die Spannmittel eine Vielzahl von Gewindemittel, die durch ein Gewinde mit dem Kühlblock verbunden sind, aufweisen, wobei mindestens eines der Vielzahl von Gewindemitteln mindestens eines der Flügelteile jedes der Befestigungsblöcke auf dem Kühlblock sichert.

10. Laserdiodenbaueinheit nach Anspruch 9, wobei die Vielzahl von Gewindemitteln eine Vielzahl von Schrauben aufweist.

11. Laserdiodenbaueinheit nach Anspruch 1, wobei jeder Befestigungsblock der Vielzahl von Laserdiodenunterbaueinheiten weiter eine geformte Bodenfläche aufweist, und wobei jede gestufte Befestigungsfläche des Kühlblocks entsprechend geformt ist, sodass jeder Befestigungsblock in jeder gestuften Befestigungsfläche aufgenommen werden kann.

12. Laserdiodenbaueinheit nach Anspruch 1, wobei die Vielzahl von gestuften Befestigungsflächen von ansteigender Höhe relativ zu einer Ebene gemessen sind, die einem untersten Teil einer Unterseite eines Kühlblocks entspricht.

13. Laserdiodenbaueinheit nach Anspruch 1, wobei eine Unterseite des Kühlblockes abgeschrägt ist.

14. Laserdiodenbaueinheit nach Anspruch 13, wobei ein Trennungsabstand, der dem Abstand zwischen jeder der Vielzahl von gestuften Befestigungsflächen des Kühlblocks und der abgeschrägten Unterseite des Kühlblockes entspricht, für jede der Vielzahl von gestuften Befestigungsflächen derselbe ist.

15. Laserdiodenbaueinheit nach Anspruch 1, wobei jede der Laserdiodenunterbaueinheiten weiter eine erste Strahlaufbereitungslinse, die auf dem Befestigungsblock befestigt ist, aufweist, wobei ein Ausgangstrahl von der Laserdiode durch die erste Strahlaufbereitungslinse hindurchgeht.

16. Laserdiodenbaueinheit nach Anspruch 15, wobei jede der Laserdiodenunterbaueinheiten weiter eine zweite Strahlaufbereitungslinse, die auf dem Befestigungsblock befestigt ist, aufweist, wobei ein zweiter Ausgangstrahl von einer anderen Laserdiodenunterbaueinheit der Vielzahl von Laserdiodenunterbaueinheiten durch die zweite Strahlaufbereitungslinse hindurchgeht.

17. Laserdiodenbaueinheit nach Anspruch 1, weiter aufweisend eine Vielzahl von elektrischen Verbindungen, wobei die Spannmittel den elektrischen Kontakt zwischen jeder der Vielzahl von elektrischen Verbindungen und einer entsprechenden Vielzahl von elektrischen Kontaktfeldern aufrechterhalten, wobei die Vielzahl von elektrischen Kontaktfeldern auf der Laserdiodenunterbefestigung der Laserdiodenunterbaueinheit angeordnet sind.

18. Laserdiodenbaueinheit nach Anspruch 1, wobei die Laserdiode eine Einfach-Emitter Laserdiode ist.

19. Laserdiodenbaueinheit nach Anspruch 1, wobei die Laserdiode eine Multi-Emitter-Laserdiode ist.

## Revendications

1. Ensemble de diodes laser comprenant :
un bloc de refroidissement comprenant une pluralité de surfaces de montage à gradins ;
une pluralité de sous-ensembles de diode laser, dans laquelle chacun desdits sous-ensembles de diode laser comprend :
- un bloc de montage, dans lequel ledit bloc de montage ne comprend pas de passages de réfrigérant intégraux et dans lequel ledit bloc de montage comprend en outre au moins une portion d'aile ;
- une sous-monture de diode laser montée sur ledit bloc de montage ; et
- une diode laser montée sur ladite sous-monture de diode laser ; et
des moyens pour serrer au moins une desdites au moins une portion d'aile de chacun desdits blocs de montage sur ledit bloc de refroidissement, où chaque faisceau de sortie provenant de ladite pluralité de sous-ensembles de diode laser est décalé par rapport à un faisceau de sortie adjacent provenant d'un sous-ensemble de diode laser adjacent.

2. Ensemble de diodes laser selon la revendication 1, dans lequel chaque bloc de montage de ladite pluralité de sous-ensembles de diode laser comprend une paire desdites portions d'aile.

3. Ensemble de diodes laser selon la revendication 1, dans lequel lesdits moyens de serrage comprennent une pluralité d'éléments de serrage.

4. Ensemble de diodes laser selon la revendication 3, dans lequel lesdits moyens de serrage comprennent en outre une pluralité de moyens filetés couplés par vissage dans ledit bloc de refroidissement.

5. Ensemble de diodes laser selon la revendication 4, dans lequel au moins un de ladite pluralité de moyens de serrage et au moins un de ladite pluralité de moyens filetés fixent au moins une desdites portions d'aile de chacun desdits blocs de montage sur ledit bloc de refroidissement.

6. Ensemble de diodes laser selon la revendication 4, dans lequel au moins un de ladite pluralité de moyens de serrage et au moins un de ladite pluralité de moyens filetés fixent chacune desdites portions d'aile de chacun desdits blocs de montage sur ledit bloc de refroidissement.

7. Ensemble de diodes laser selon la revendication 4, dans lequel ladite pluralité de moyens filetés comprend une pluralité de boulons.

8. Ensemble de diodes laser selon la revendication 1, dans lequel chaque bloc de montage de ladite pluralité de sous-ensembles de diode laser comprend une paire desdites portions d'aile, dans lequel lesdits moyens de serrage comprennent une pluralité d'éléments de serrage, dans lequel lesdits moyens de serrage comprennent en outre une pluralité de moyens filetés couplés par vissage dans ledit bloc de refroidissement et dans lequel au moins un de ladite pluralité de moyens de serrage et au moins un de ladite pluralité de moyens filetés fixent chacune desdites portions d'aile de ladite paire de portions d'aile de chacun desdits blocs de montage sur ledit bloc de refroidissement.

9. Ensemble de diodes laser selon la revendication 1, dans lequel lesdits moyens de serrage comprennent en outre une pluralité de moyens filetés couplés par vissage dans ledit bloc de refroidissement, dans lequel au moins un de ladite pluralité de moyens filetés fixe au moins une desdites portions d'aile de chacun desdits blocs de montage sur ledit bloc de refroidissement.

10. Ensemble de diodes laser selon la revendication 9, dans lequel ladite pluralité de moyens filetés comprend une pluralité de boulons.

11. Ensemble de diodes laser selon la revendication 1, dans lequel chaque bloc de montage de ladite pluralité de sous-ensembles de diode laser comprend en outre une surface inférieure profilée et dans lequel chaque surface de montage à gradins dudit bloc de refroidissement est profilée de manière correspondante afin que chaque bloc de montage soit en correspondance avec chaque surface de montage à gradins.

12. Ensemble de diodes laser selon la revendication 1, dans lequel ladite pluralité de surfaces de montage à gradins est d'une hauteur croissante telle que mesurée par rapport à un plan correspondant à une portion la plus basse d'une surface inférieure du bloc de refroidissement.

13. Ensemble de diodes laser selon la revendication 1, dans lequel une surface inférieure dudit bloc de refroidissement est inclinée.

14. Ensemble de diodes laser selon la revendication 13, dans lequel une distance de séparation correspondant à la distance entre chacune de ladite pluralité de surfaces de montage à gradins dudit bloc de refroidissement et ladite surface inférieure inclinée du bloc de refroidissement est la même pour chacune de ladite pluralité de surfaces de montage à gradins.

15. Ensemble de diodes laser selon la revendication 1, dans lequel chacun desdits sous-ensembles de diode laser comprend en outre une première lentille de conditionnement de faisceau montée sur ledit bloc de montage, dans lequel un deuxième faisceau de sortie provenant de ladite diode laser passe à travers ladite première lentille de conditionnement de faisceau.

16. Ensemble de diodes laser selon la revendication 15, dans lequel chacun desdits sous-ensembles de diode laser comprend en outre une deuxième lentille de conditionnement de faisceau montée sur ledit bloc de montage, dans lequel un deuxième faisceau de sortie provenant d'un sous-ensemble de diode laser différent de ladite pluralité de sous-ensembles de diode laser passe à travers ladite deuxième lentille de conditionnement de faisceau.

17. Ensemble de diodes laser selon la revendication 1, comprenant en outre une pluralité d'interconnexions électriques, dans lequel lesdits moyens de serrage maintiennent chacune de ladite pluralité d'interconnexions électriques en contact électrique avec une pluralité correspondante de pastilles de contact électrique, dans lequel ladite pluralité pastilles de contact électrique est située sur lesdites sous-montures desdits sous-ensembles de diode laser.

18. Ensemble de diodes laser selon la revendication 1, dans lequel ladite diode laser est une diode laser à émetteur unique.

19. Ensemble de diodes laser selon la revendication 1, dans lequel ladite diode laser est une diode laser à émetteurs multiples.
